**Europäisches Patentamt**

**European Patent Office**

**Office européen des brevets**

(19)

(11) Veröffentlichungsnummer: **0 002 795**
**B1**

(12) **EUROPÄISCHE PATENTSCHRIFT**

(45) Veröffentlichungstag der Patentschrift: **13.01.82**

(51) Int. Cl.³: **G 03 F 7/02, G 03 F 1/00**

(21) Anmeldenummer: **78101785.0**

(22) Anmeldetag: **20.12.78**

(54) Verfahren zum Erzeugen von Masken für lithographische Prozesse unter Verwendung von Photolack.

(30) Priorität: **30.12.77 US 865814**

(43) Veröffentlichungstag der Anmeldung:
**11.07.79 Patentblatt 79/14**

(45) Bekanntmachung des Hinweises auf die Patenterteilung:
**13.01.82 Patentblatt 82/2**

(84) Benannte Vertragsstaaten:
**DE FR GB**

(56) Entgegenhaltungen:
DE - A - 2 061 580
DE - C - 541 308
FR - A - 2 263 605
JP - A - 114 931/76
US - A - 3 849 136
US - A - 3 934 057
US - A - 3 954 469
US - A - 4 024 122
US - A - 4 024 293

IBM TECHNICAL DISCLOSURE BULLETIN, vol. 9,
nr. 4, September 1966
New York, U.S.A.
R.P. ESCH et al. "Obtaining Evaporated metal patterns on Substrates", Seiten 348 bis 349
IBM TECHNICAL DISCLOSURE BULLETIN, vol.
18, nr. 12, Mai 1976
New York, U.S.A.

(73) Patentinhaber: International Business Machines
Corporation
Armonk, N.Y. 10504 (US)

(72) Erfinder: Feng, Bai-Cwo
7F White Gates Apts
Wappingers Fall NY 12590 (US)
Erfinder: Feng, George Cheng-Cwo
164 South Avenue
Poughkeepsie NY 12601 (US)

(74) Vertreter: Blutke, Klaus Wilhelm (DE)
Schönaicher Strasse 220
D-7030 Böblingen (DE)

(56) Entgegenhaltungen:
L.T. ROMANKIW et al: "Interlayer technique for
use to form evaporation Lift-off masks", Seiten
4219 bis 4221
JAPANESE PATENTS GAZETTE, Part I Section
G; 5. Januar 1977
London, G.B.
"Forming photoresist patterns on semiconductor
base by irradiating first and second photoresist
layers with UV through mask", Seite 5, Abstract
No. G 06 87937 x/47

# 0 002 795

Verfahren zum Erzeugen von Masken für lithographische Prozesse unter Verwendung von Photolack

Die Erfindung betrifft ein Verfahren zum Erzeugen von Masken für lithographische Prozesse unter Verwendung von aus einem Sensibilisator, Harzen und Lösungsmitteln bestehenden Photolackschichten, welche selektiv belichtet und entwickelt werden, wobei auf ein Substrat (20) eine erste Photolackschicht (21) und nachfolgend auf diese mindestens eine zweite Photolackschicht (22) aufgebracht wird, und wobei die Photolackschichten unterschiedliche Lösungsraten im Entwickler haben, so daß durch dessen Einwirkung die in den Schichten entwickelten Bereiche unterschiedlich groß sind unter Ausbildung von in den freizulegenden Bereich der ersten Photolackschicht überstehenden Rändern der zweiten Photolackschicht.

Die Technik der additiven Metallisierung, als Abheben bekannt, wurde Ende der 60er Jahre in der Elektronenstrahl-Lithographie entwickelt. Dabei ist die Metallisierung nach der Belichtung und Entwicklung des Resistmaterials vorgesehen. Die Abhebetechnik nutzt grundsätzlich die Tatsache, daß die Streuung von Elektronen im Resistmaterial und deren Rückstreuung vom Substrat im Resistmaterial ein tränenförmiges Energie-Absorptionsprofil schafft, das zu einem unterschnittenen Profil nach Entwicklung des Resistmaterials führt. Auf diese Weise zeigt über der ganzen Oberfläche aufgedampftes Metall Diskontinuitäten zwischen dem Metall auf dem Substrat und dem Metall über dem Resistmaterial. Während der Entfernung des Resistmaterials in einem geeigneten Lösungsmittel wird auch das Metall über dem Resistmaterial entfernt und eine saubere und zuverlässige Reproduktion des Bildes im Metall erzeugt. Ein zusätzlicher Vorteil der Abhebetechnik liegt darin, daß mehrstufige Metallstrukturen gebildet werden können, weil jedes Material oder jede Materialkombination eingesetzt werden kann, die sich verdampfen läßt.

Einer der Hauptgründe für den Erfolg des Abhebeprozesses in der Elektronenstrahllithographie ist die Tatsache, daß die Energieabsorption im Resistfilm während der Belichtung nicht linear verläuft, sondern bei etwa zwei Dritteln des Eindringbereiches des Strahlens einen Höchstwert erreicht. Bei richtiger Belichtung und Entwicklung lassen sich also leicht unterschnittene Widerstandsprofile erzielen.

Bei der optischen Belichtung von Photoresistmaterial (Photowiderstandsmaterial; Photolack) ist die Energieabsorption jedoch an der Oberseite des Resistfilmes am höchsten und an der Schnittfläche zwischen Resistmaterial und dem Substrat aufgrund der Lichtdämpfung im Resistmaterial am niedrigsten. Außerdem stellen durch das vom Substrat reflektierte Licht geschaffene stehenden Wellen eine weitere Komplikation dar. Diese Belichtungsbedingungen machen es unmöglich, unterschnittene oder nur vertikale Widerstandsprofile mit normaler UV-Belichtung bei einem positiven Photowiderstandsmaterial aus einem organischen Polymer wie z.B. AZ 1350 = 4'-2'-3'-Dihydroxybenzophenonester.

Eine weitere in der Elektronenstrahllithographie erfolgreich eingesetzte Technik ist die Erhöhung der Empfindlichkeit des Resistmaterials, während man das Unterschneiden des entwickelten Resistmaterials beibehält, wozu das Überziehen von zwei oder mehr Resistschichten mit stark unterschiedlicher Löslichkeit gehört. Nach Belichtung durch den Elektronenstrahl wird ein Entwickler gewählt, der die obere Schicht wenigstens zehn Mal langsamer entwickelt als die untere Schicht. Andererseits können für die aufeinander folgende Entwicklung der beiden Schichten auch zwei sich gegenseitig ausschließende Entwickler verwendet werden. Beide Lösungen führen zu Widerstandsprofilen, die für die Abhebemetallisierung geeignet sind.

Bei Resistmaterialien, die sowohl in optischen als auch in Elektronenstrahl-Belichtungssystemen verwendet werden können, ist es jedoch schwierig, zwei verschiedene Schichten dünn auszubilden, ohne an der Schnittfläche eine zu große Wechselwirkung zu bekommen, was auf die niedrige Vorwärmtemperatur ("Vorbacken") zurückzuführen ist, die für diese Resistmaterialien zwischen dem Aufbringen der einzelnen Überzüge gestattet ist. Elektronenresistmaterialien wie Polymethylmethacrylat (PMMA) können bis auf 170° ohne Verschlechterung erwärmt werden. Ein Resistmaterial vom Typ eines organischen Polymers, das sowohl für die optische Belichtung als auch für die Belichtung durch Elektronenstrahl geeignet ist, kann jedoch nicht über 100°C aufgeheizt werden. Bei dieser niedrigen Temperatur behält der Resistfilm seine Löslichkeit in verschiedenen Lösungsmitteln bei und läßt sich daher durch Auftragen der zweiten Schicht leicht auflösen.

Ausgehend von den Ergebnissen mit Elektronenstrahl-Widerstandsmaterialien wurde daher bekannt, daß die Anwendung von zwei Schichten eines Standard-Photoresistmateriales, von denen die erste Schicht in einem Entwickler löslicher ist als die andere, zur Bildung einer Reliefmaske mit vertieften Seitenwänden für einen Abhebeprozeß benutzt werden kann. Diese Strukturat läßt sich auf verschiedene Weise herstellen: (1) Durch Reduzierung der Konzentration des Sensitivierungsmittels im unteren Teil; (2) durch Verwendung im oberen Teil eines Harzes mit einem höheren Molekulargewicht als der untere Teil der Resiststruktur, der sich schneller entwickelt als der obere Teil oder (3) durch Verwendung eines Sensitivierungsmittels im unteren Teil der Struktur, das im Falle eines positiven Resistes für den Entwickler weniger widerstandsfähig ist.

Wenn jedoch die zweite Schicht eines optischen Resistmaterials vor der Belichtung direkt auf die erste Schicht aufgetragen wird, dann lösen sich die Schichten auf, wie bereits gesagt, und mischen sich miteinander. Wenn die erste Schicht bei einer höheren Temperatur gehärtet wird, um diese Auflösung zu vermeiden, dann härtet sie aus und wird im Entwickler unlöslich.

In der US - A - 3 934 057 — insbesondere im Zusammenhang mit Fig. 5c — ist ein Verfahren zur Maskenherstellung unter Verwendung von hochempfindlichen Photolackschichten unterschiedlicher Lösungsraten im Entwickler zur Herstellung "unterschnittener Profile" beschrieben.

Ein erfolgreicher Abhebeprozeß, der optische Standardresistmaterialien verwendet, ist in der US-Patentschrift Nr. 4 004 044 beschrieben. Das Verfahren umfaßt den Niederschlag einer aus organischem Polymer wie z.B. einer aus 4'-2'-3'-Dihydroxybenzophenonester bestehenden Maskenschicht als Resistmaterial auf einem Substrat. Nach dem Härten zur Verbesserung der Haftung und thermischen Stabilität wird auf das Resistmaterial eine separate Glasharzschicht aufgesponnen. Auf der Resistschicht wird dann eine zweite Maskierungsschicht aufgesponnen, die ebenfalls aus 4'-2'-3'-Dihydroxybenzophenonester bestehen kann. Die zweite Maskierungsschicht wird gemustert und in der Glasschicht und der ersten Maskierungsschicht durch reaktive Sprühätzung mit zwei Gasen werden Ausschnitte erzeugt. Der zweite reaktive Sprühschritt wird fortgesetzt, bis die Kanten der Ausschnitte durch das Glasmaterial die Kanten in den Ausschnitten durch die erste Schicht überlagern; so daß auf diese Weise eine Abhebemaske gebildet wird. Obwohl diese Technik sehr brauchbare Abhebemasken liefert, ist sie jedoch dadurch kompliziert, daß die Glasharzschicht, die reaktive Sprühätzung und relativ hohe Temperaturen benötigt werden. Daher ist ein einfacher Prozeß erwünscht.

Es ist deshalb Aufgabe der Erfindung, eine zusammengesetzte Resist-Struktur aus herkömmlichen Photolacken zu bilden für einen verbesserten Abhebeprozeß zur Bildung selektierbarer Widerstandsprofile. Diese Struktur soll insbesondere in Niedrig-Temperatur-Prozessen gebildet werden.

Die Aufgabe der Erfindung wird in vorteilhafter Weise dadurch gelöst, daß auf ein Substrat 20 eine erste Photolackschicht 21 und nachfolgend auf diese mindestens eine zweite Photolackschicht aufgebracht wird, wobei die zweite Photolackschicht 22 mit einem Verdünnungsmittel gesättigt ist, in welchem der Sensibilisator und das Harz nicht lösbar ist und welches sich mit den Lösungsmitteln mischen läßt, und daß die Photolackschichten 21, 22 unterschiedliche Lösungsraten im Entwickler haben, so daß durch dessen Einwirkung die in den Schichten 21, 22 entwickelten Bereiche unterschiedlich groß sind unter Ausbildung von in den freizulegenden Bereich 23 der ersten Photolackschicht 21 überstehenden Rändern der zweiten Photolackschicht 22.

Die beiden Schichten können aus dem gleichen herkömmlichen Standard-Resistmaterial oder aus unterschiedlichen Resistmaterialien bestehen, von denen das eine wieder ein Standard-Resistmaterial sein kann.

Die untere Resist-Schicht wird so vorbereitet, daß sie in dem Entwickler des Resistmaterials stärker löslich ist als die über ihr liegende Schicht. Bei Belichtung und Entwicklung überlagert die obere Schicht die untere.

Die meisten Photowiderstandsmaterialien (Photoresistmaterialien, Photolacke) bestehen aus drei Hauptteilen: Einem Sensibilisator, einem Harz und einem oder mehreren Lösungsmitteln. Jedes Lösungsmittel hat eine maximale Löslichkeit für ein bestimmtes Material. In einem Photoresistmaterial können verschiedene Lösungsmittel als Lösungssystem eingesetzt werden, das die maximale Löslichkeit für den Sensibilisator und das Harz bildet. Wenn diese im Lösungssystem aufgelösten festen Stoffe eine maximale Löslichkeit erreichen, d.h., die Sättigung, so wurde festgestellt, daß dieses gesättigte Photoresistmaterial ein darunterliegendes Photoresistmaterial desselben oder eines ähnlichen Typs nicht auflöst. Diese Art System ist jedoch nicht geeignet, weil es extrem dick ist und weil es Schwierigkeiten in der Herstellung und aufgrund der Viskosität Schwierigkeiten in der Handhabung und Anwendung aufweist.

Es wurde erfindungsgemäß festgestellt, daß diese Schwierigkeiten vermieden werden, wenn man das Resistmaterial mit einem Material sättigt, in dem der Sensibilisator und das Harz im Photoresistmaterial nicht löslich sind und welches sich mit den Lösungsmitteln im Photoresistmaterial mischen läßt. Ein derartiges Material wird Verdünnungsmittel genannt.

In einem bevorzugten Ausführungsbeispiel der Erfindung wird ein Verdünnungsmittel wie beispielsweise Xylol mit einer Standardresistlösung gemischt, die ein Phenol-Formaldehydharz und einen Sensibilisator aus Diazooxid bis zum Sättigungspunkt enthält. Wenn diese Lösung auf einer Schicht aus vorgehärtetem Standardresistmaterial niedergeschlagen wird, treten die Schichten nicht in nennenswerte Wechselwirkung.

Der erfindungsgemäße Prozeß ist besonders wirksam in der Abhebe-Technik bei der Herstellung von Josephson-Dünnfilmelementen; hierbei sind für die Resistprozesse niedrige Temperaturen vorgeschrieben. Bei Josephson-Elementen schädigen Herstellungstemperaturen von mehr als etwa 70°C die Oxidschicht, die nur $5 \cdot 10^{-9}$ dick ist. Die Metallisierung des Elementes, ausgelegt für den Betrieb auf Kryogen-Niveau, ist ebenfalls annehmbar. Der erfindungsgemäße Prozeß gestattet die Verwendung von Resistmaterial, das effektiv bei Härtetemperaturen bis zu 70°C benutzt werden kann.

Ein Ausführungsbeispiel der Erfindung ist in den Zeichnungen dargestellt und wird im folgenden näher beschrieben. Es zeigen:

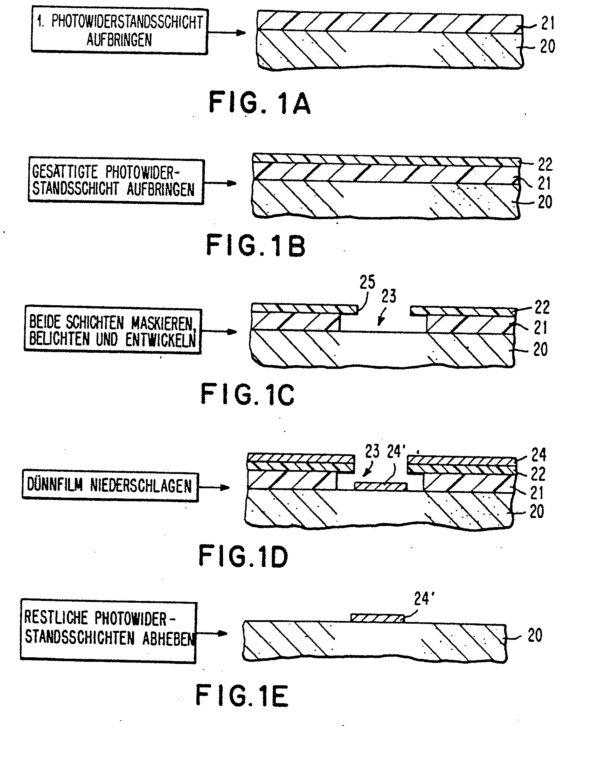

In den Fign. 1A bis 1E sind Schnittansichten eines Metallisierungsprozesses in Abhebetechnik gezeigt. Außerdem enthalten diese Fign. die einzelnen Schritte beschreibende Hinweise.

Die Fign. 1A bis 1E zeigen die Bildung einer zusammengesetzten Maske sowie deren Benutzung für Abhebezwecke.

**0 002 795**

In Fig. 1A ist eine organische Polymermaskenschicht 21 auf einem Substrat 20 dargestellt. Die Schicht 21 besteht vorzugsweise aus einem positiven Resistmaterial wie einem organischen Polymer (z.B. AZ—1350J), das zur Verbesserung der Haftung auf dem Substrat 20 gehärtet wird. Die Dicke der Schicht 21 bestimmt die größte Dicke des Funktionsfilmes, der bei Entfernung der Schicht 21 abgehoben werden kann. Die Schicht 21 hat eine typische Dicke von $10^{-6}$m bis $2 \cdot 10^{-6}$m.

Bei der Herstellung integrierter Schaltungen kann das Substrat 20 aus einem Halbleitermaterial oder einem Halbleitersubstrat bestehen, dessen Oberflächenschicht elektrisch isolierendes Material wie beispielsweise Siliciumdioxid ist.

Das bevorzugte organische Polymer-Maskenmaterial AZ—1350J besteht aus einem Phenolformaldehyd-Novolak-Harz und einer lichtempfindlichen Diazooxid-Verbindung, die in einem Verdünner für das Polymer-Maskenmaterial aufgelöst ist. (Das Material AZ—1350 ist im Handel verfügbar.) Andere geeignete Photoresistmaterialien umfassen Diazo-Photoresiste und andere Materialien sowie negative Resistmaterialien wie das von der Kodak Corporation gelieferte KTFR (teilweise cyklisiertes Poly-cis-Isopren) und Harze wie beispielsweise Polyviny-Cinnamat.

Nach Darstellung in Fig. 1B wird eine Schicht ausgesättigtem Resist 22 auf die Schicht 21 aufgetragen. Bei der Verwendung von organischem Polymer oder dergleichen als Grundschicht 21 wird dieses Material vorzugsweise auch als Oberschicht verwendet. Das Sättigungsmaterial, d.h., das Verdünnungsmittel, kann entweder Xylol oder Toluol oder Chlorbenzol oder fluorierter Kohlenwasserstoff sein.

Das gesättigte Resistmaterial 22 enthält eine größere Menge photosensitiven Materials oder hat ein größeres Molekulargewicht als die Resistschicht 21. Durch jedes dieser Materialien wird die Schicht 22 für den Entwickler unempfindlicher als die Schicht 21.

Nach Darstellung in Fig. 1B wird die Schicht aus gesättigtem Resistmaterial 22 auf die Schicht 21 in einer typischen Dicke zwischen $3 \cdot 10^{-7}$ m und $3,5 \cdot 10^{-7}$ m aufgetragen. Das Substrat wird dann vorgehärtet. Da die Schicht 22 jedoch gesättigt ist, ist die Mischung der Schichten 21 und 22 unwesentlich.

Öffnungen wie die Öffnung 23 werden in den Schichten 22 und 21 in herkömmlicher Lithographietechnik durch Belichtung mit einem optischen Lichtstrahl oder einem Elektronenstrahl erzeugt. Wegen der geringeren Empfindlichkeit der oberen Schicht 22 gegenüber der unteren Schicht 21 für den Entwickler, neigt letztere dazu, im Entwickler schneller zu ätzen und ergibt dadurch die Abhebestruktur mit dem Überhang 25. Der Überhang 25 in der Schicht 22 gestattet ein beträchtliches Überätzen der Schicht 21, um sicherzustellen, daß das gesamte Material der Schicht 21 an den Stellen der gewünschten Öffnung 23 entfernt wurde. Außerdem wird durch den Überhang ein Ausfransen der Kanten vermieden, wenn das Dünnfilmmaterial in nachfolgenden Prozeßschritten abgehoben wird. Die Musterabmessungen des durch die Öffnung 23 auf dem Substrat niederzuschlagenden Dünnfilmmaterials wird durch die Größe der Überhangöffnung in der Schicht 22 bestimmt.

Als nächstes wird ein Metallfilm 24 über der Struktur gemäß Fig. 1C niedergeschlagen, wie es in Fig. 1D dargestellt ist. Dieser Film kann aus jedem für die Metallisierung integrierter Schaltungen geeigneten Metall bestehen, beispielsweise aus Aluminium, Aluminium-Kupferlegierungen, Legierungen aus Aluminium-Kupfer und Silicium, Palladium, Chrom, Platin, Tantal usw. Die Schicht 24 kann ebenfalls ein Isolator sein, beispielsweise aus Siliciumdioxid oder Siliciumnitrid.

Im letzten Schritt des Abhebeprozesses wird die Photoresistschicht 21 vollständig durch Eintauchen in ein Lösungsmittel wie Aceton oder in ein anderes Photoresistlösungsmittel für etwa 15 bis 30 Minuten entfernt, wodurch die Dünnfilmschicht 24' in der gewünschten Musterkonfiguration gemäß Darstellung in Fig. 1E übrigbleibt. Als Lösungsmittel sollte ein Mittel gewählt werden, das das Polymermaterial der Schicht 21 auflöst oder aufquellen läßt, ohne den Dünnfilm 24' zu beeinflussen. Zu solchen Lösungsmitteln gehören NMP (N-Methylpyrrolidon), Methyläthylketon oder Trichloräthylen. Die zum Ablösen des Polymermaterials verwendeten Lösungsmittel können dieselben sein, die zum Auftragen der Polymerschicht 21 benutzt wurden.

Beispiel 1

Ein positives Resistmaterial ist mit Phenolformaldehyd-Novolakharz und einem Diazoketon-Sensibilisator hergestellt (und im Handel als AZ—1350J verfügbar). Das Sensitivierungsmittel besteht vermutlich aus gemischten 4'-2'-3'-Dihydroxybenzophenonestern der 1-Oxo-2-diazonaphthalen-5-sulfon-Säure. Andere schwefelige Ester des Dihydroxy-benzophenon können ebenfalls verwendet werden. Diese Feststoffe sind in Äthylglykolacetat oder Verdünner für organische Polymere gelöst, der 82,6 % Äthylcellosolveacetat, 8,8 % n-Butylacetat und 8,6 % Xylol enthält. (Das Wort Cellosolve ist ein Warenzeichen).

Diese Widerstandslösung wird dann mit einem Verdünnungsmittel wie Xylol, Toluol, Chlorbenzol oder fluoriertem Kohlenwasserstoff gemischt. Das Verdünnungsmittel wird dem gelösten Resistmaterial schrittweise durch mechanisches Umrühren zugegeben. Bei einer Konzentration von etwa zwei Teilen Xylol und einem Teil gelöster Resistlösung scheiden sich genügend Feststoffe einschließlich des Resistharzes und des Sensibilisators aus. Das ganze Gemisch wird dann durch Sub-Mikronfilter gefiltert, wobei das gefilterte Gemisch gesättigtes Resistmaterial genannt wird.

Bei der Bildung des zusammengesetzten Schicht wird das Substrat vorgereinigt, mit einem Ober-

4

flächenhauftmittel wie Hexamethyldisilazon behandelt und das Resistmaterial ohne genanntes Verdünnungsmittel darauf bis zu einer Dicke von etwa $18 \cdot 10^{-7}$ m aufgetragen. Das Resistmaterial wird bei 70 bis 100°C für 10 bis 15 Minuten lang vorgehärtet.

Besagtes gesättigtes Resistmaterial wird dann auf das Originalresistmaterial bis zu einer Dicke von etwa $12 \cdot 10^{-8}$ m als Schicht 22 aufgetragen. Dann wird das Vorhärten wiederholt, wodurch die zusammengesetzte Resiststruktur benutzungsbereit entsteht, wie es in Fig. 1B gezeigt ist.

Nach diesem zweiten Vorhärten wird die Schicht 22 von etwa $12 \cdot 10^{-8}$ m auf $3 \cdot 10^{-7}$ m durch ihre Wechselwirkung mit der Schicht 21 verdickt. Das hat jedoch keinen wesentlichen Einfluß auf die weitere Verarbeitung wegen der Dicke der Schicht 21. Die Anwendung von dem organischen Polymer AZ—1350J ergibt typischerweise eine Resistschicht von etwa $18 \cdot 10^{-7}$ m Dicke. Auch bei einer Verdünnung von drei Teilen AZ—1350J mit einem Teil AZ darin ist die Schicht 21 immer noch rund $12 \cdot 10^{-7}$ m dick.

Wenn die in Fig. 1C gezeigte Abhebestruktur erwünscht ist, wird die Schicht 21 so bereitet, daß sie sich schneller im Resistentwickler auflöst als die Schicht 22. Dazu bildet man die Resistschicht 21 am besten mit einem niedrigeren Molekulargewicht aus als die Resistschicht 22. (Das in der US-Patentschrift Nr. 3 666 473 beschriebene Resistmaterial ist für die Schicht 21 geeignet.) Andererseits kann aber auch die Konzentration des Sensitivierungsmittels in der Schicht 21 gegenüber der in der Schicht 22 reduziert werden. Dazu benutzt man am besten das Resistmaterial AZ—1350J als Schicht 21 und gibt eine bestimmte Menge besagten Sensibilisators zu einem anderen Teil von AZ—1350J hinzu, um besagtes gesättigtes Resistmaterial als Schicht 22 herzustellen. So werden z.B. 20 Gramm Sensitivierungsmittel gelöst in 80 Gramm Lösungsmittel. Diese Lösung wird zu 20 ml des Materials AZ—1350J hinzugefügt, so daß sich eine Resistlösung bildet, die dann mit Xylol gesättigt wird. Diese Lösung wird als Schicht 22 aufgetragen.

Die Schicht 22 wird so maskiert, daß das gewünschte Muster von Öffnungen definiert ist; sie wird dann mit einer aktinischen Lichtquelle zwischen $2 \cdot 10^{-7}$ m und $4 \cdot 10^{-7}$ m belichtet. Die belichteten Bereiche werden dann in einem alkalischen Entwickler, z.B. AZ—Entwickler aufgelöst und ergeben die in Fig. 1C gezeigte Struktur.

## Beispiel 2

Durch Zugabe von vier Teilen Xylol zu einem Teil aufgelöster Resistlösung kann man mehr feste Bestandteile ausfällen. Das resultierende gesättigte Resistmaterial ist dünner als das im Verhältnis 2:1 gesättigte Resistmaterial im Beispiel 1. Beim Auftragen des Standardresistmaterials wird die Dicke der gesättigten Resistmaterialschicht auf etwa $6 \cdot 10^{-8}$ m reduziert und außerdem tritt dann eine geringere Wechselwirkung zwischen den beiden Resistschichten auf.

## Beispiel 3

Das Auftragen von mehr als einem Überzug gesättigten Resistmaterials wirkt sich gut auf die Steuerung des Resistmaterialprofiles nach der Belichtung aus. Eine dünne gesättigte Resistmaterialschicht, die wie im Beispiel 2 angeführt hergestellt ist, kann z.B. zuerst oben auf die Standardresistschicht 21 aufgetragen werden. Dieser Schicht folgt ein oder mehrer Überzüge mit den gesättigten Resistmaterialien, die wie in den Beispielen 1 oder 2 hergestellt sind, und ergeben eine zusammengesetzte Schicht der gewünschten Dicke aus gesättigtem Resistmaterial.

## Beispiel 4

Ein negatives Resistmaterial wird mit einem Harz des cyklisierten Gummis Poly-Cis-Isopren und einem Sensibilisator hergestellt, der 2,6-Bis(para-azidobenzyliden)-4-methylcyclohexan ist. Diese Feststoffe werden in Xylol gelöst.

Ein Teil der gelösten Resistlösung wird dann mit einem Verdünnungsmittel aus fluoriertem Kohlenwasserstoff gemischt, das in Äthylglykolacetat im Verhältnis 1:1 enthalten ist. Das wird dann schrittweise durch mechanisches Umrühren dem gelösten Resistmaterial zugegeben.

Bei einer Konzentration von etwa Teil Verdünnung-Äthylglycolacetat und einem Teil gelösten Resistmaterial fällen die Feststoffe einschließlich des Resistharzes und des Sensibilisators aus. Das ganze Gemisch wird dann durch ein Sub-Mikronfilter gefiltert und ist das gesättigte Resistmaterial.

Bei der Bildung der zusammengesetzten Schicht wird das Substrat vorgereinigt, mit einem Oberflächenhaftungsmittel wie Hexamethyldisilazan behandelt und der übrige Teil des Originalresistmaterials darauf aufgetragen. Das Resistmaterial wird bei 80 bis 100°C 10 bis 15 Minuten lang vorgehärtet. Besagtes gesättigtes Resistmaterial wird dann oben auf das ungesättigte Resistmaterial aufgetragen. Dann wird wieder vorgebacken, wodurch die gesamte Resistmaterialstruktur als Resistmaske benutzungsbereit ist.

Die zusammengesetzte Struktur wird so maskiert, daß das gewünschte Negativmuster von Öffnungen definiert wird, und wird dann einer Belichtung durch eine aktinische Lichtquelle zwischen $2 \cdot 10^{-7}$ m und $4 \cdot 10^{-7}$ m ausgesetzt. Die nicht belichteten Bereiche werden dann in Xylol-Entwickler gelöst und ergeben die gemusterte Maske.

Die vorliegende Erfindung bietet also die Möglichkeit, eine Maske aus mehreren Schichten Photo-

# 0 002 795

resistmaterial ohne nennenswerte Wechselwirkung zwischen diesen Schichten herzustellen. Verschiedene gemusterte Resistmaterialprofile lassen sich dadurch erreichen, daß man eine langsamere Auflösungsrate (im Resistmaterial-Entwickler) in ausgewählten Resistbereichen der zusammengesetzten Schicht vorsieht. Insbesondere ergibt das Verfahren ein erwünschtes Profil beim Unterschneiden, um eine Diskontinuität zwischen den Teilen zusätzlicher Schichten besser festlegen zu können, die auf die Oberflächen eines Resistmaterials und die Teile der Schicht aufgetragen werden, die direkt am Substrat haften.

Dieses Ergebnis erhält man durch schnellere Auflösung der darunterliegenden Resistmaterialschicht im Entwickler: Weil sich dieser Prozeß auch auf andere Resistmaterialien anwenden läßt, die kein Backen bei hohen Temperaturen erfordern, ist das Verfahren sehr effektiv bei der Bildung von Elementen, die Prozesse mit niedrigen Temperaturen verlangen wie beispielsweise bei der Herstellung von Josephson-Elementen. Diese sind jedoch hier nur als Beispiel erwähnt; das Verfahren läßt sich natürlich auch auf die Bildung von integrierten Standardschaltstrukturen sowie auf fortgeschrittene Technologien bei Blasenspeichern anwenden.

## Patentansprüche

1. Verfahren zum Erzeugen von Masken für lithographische Prozesse unter Verwendung von aus einem Sensibilisator, Harzen und Lösungsmitteln bestehenden Photolackschichten, welche selektiv belichtet und entwickelt werden, wobei auf ein Substrat (20) eine erste Photolackschicht (21) und nachfolgend auf diese mindestens eine zweite Photolackschicht (22) aufgebracht wird, und wobei die Photolackschichten unterschiedliche Lösungsraten im Entwickler haben, so daß durch dessen Einwirkung die in den Schichten entwickelten Bereiche unterschiedlich groß sind unter Ausbildung von in den freizulegenden Bereich der ersten Photolackschicht überstehenden Rändern der zweiten Photolackschicht, dadurch gekennzeichnet, daß die zweite Photolackschicht (22) mit einem Verdünnungsmittel gesättigt ist, in welchem der Sensibilisator und das Harz nicht lösbar ist und welches sich mit den Lösungsmitteln mischen läßt.

2. Verfahren nach Anspruch 1, dadurch gekennzeichnet, daß vor dem Aufbringen der zweiten Photolackschicht (22) auf die erste Photolackschicht (21) letztere (21) vorgehärtet wird.

3. Verfahren nach einem der Ansprüche 1 bis 2, dadurch gekennzeichnet, daß als Verdünnungsmittel Xylol, Toluol, Chlorbenzol oder fluorierter Kohlenwasserstoff verwendet wird.

4. Verfahren nach einem der Ansprüche 1 bis 3, gekennkzeichnet durch seine Anwendbarkeit für Härtetemperaturen um 70°C und darüber.

5. Verfahren nach einem der Ansprüche 1 bis 3, gekennzeichnet durch Schichtdicken zwischen $10^{-6}$ m und $2 \cdot 10^{-6}$ m für die erste (21) und zwischen $3 \cdot 10^{-7}$ m und $3,5 \cdot 10^{-7}$ m für die zweite Schicht (22).

## Revendications

1. Procédé pour former des masques pour des procédés lithographiques, en utilisant des couches de résine photosensible comportant un sensibilisateur, des résines et des solvants, qui sont sélectivement exposées et développées; procédé dans lequel on dépose sur un substrat (20) une première couche de résine photosensible (21) sur laquelle on dépose ensuite au moins une seconde couche de résine photosensible (22); et dans lequel les couches de résine photosensible ont différentes vitesse de solubilité dans le révélateur de sorte que, grâce à l'action de ce dernier, les régions formées dans les couches sont de dimensions différentes et que des surplombs de la second couche de résine photosensible sont formés dans la région à exposer de la première couche de résine photosensible, caractérisé en ce que la seconde couche de résine photosensible (22) est saturée avec un diluant dans lequel le sensibilisateur et la résine sont insolubles et qui peut être mélangé avec les solvants.

2. Procédé selon la revendication 1, caractérisé en ce que avant le dépôt de la seconde couche de résine photosensible (22) sur la première couche de résine photosensible (21) cette dernière (21) est prédurcie.

3. Procédé selon l'une des revendications 1 et 2, caractérisé en ce que l'on utilise comme diluant le zylène, le toluène, le chlorobenzène ou les hydrocarbures fluorés.

4. Procédé selon l'une quelconque des revendications 1 à 3, caractérisé en ce qu'il est utilisable à des températures de durcissement d'environ 70°C et plus.

5. Procédé selon l'une quelconque des revendications 1 à 3, caractérisé par une épaisseur comprise entre $10^{-6}$ m et $2 \times 10^{-6}$ m pour la première couche (21) et entre $3 \times 10^{-7}$ m et $3,5 \times 10^{-7}$ m pour la seconde couche (22).

## Claims

1. Method for forming a mask for a lithographic process using photoresist layers each comprising a sensitizer, a resin and a solvent and which are selectively exposed and developed, wherein a first photoresist layer (21) is deposited on a substrate (20) and subsequently at least one second photoresist layer (22) is deposited atop the first layer (21), and wherein the photoresist layers have different solubility rates in the developer so that areas simultaneously exposed and developed in the layers are of different size with the edges of the second photoresist layer overhanging the edges of the first photoresist layer, characterized in that the second photoresist layer (22) is saturated with a diluent in which the sensitizer and resin are insoluble and which can be mixed with the solvent.

2. Method as in claim 1, characterized by prebaking the first photoresist layer (21) prior to the application of the second photoresist layer (22) atop the first layer (21).

3. Method as in claims 1 and 2, characterized by the use of xylene, toluene, chlorobenzene or fluorinated hydrocarbon as the dilutant.

4. Method as in one of the claims 1 to 3, characterized by its applicability to baking temperatures of about 70°C and above.

5. Method as in one of the claims 1 to 3, characterized by a thickness of between $10^{-6}$ m and $2 \times 10^{-6}$ m for the first layer (21) and between $3 \times 10^{-7}$ m and $3.5 \times 10^{-7}$ m for the second layer (22).

| 1. PHOTOWIDERSTANDSSCHICHT AUFBRINGEN | → |
|---|---|

**FIG. 1A**

| GESÄTTIGTE PHOTOWIDER- STANDSSCHICHT AUFBRINGEN | → |
|---|---|

**FIG.1B**

| BEIDE SCHICHTEN MASKIEREN, BELICHTEN UND ENTWICKELN | → |
|---|---|

**FIG.1C**

| DÜNNFILM NIEDERSCHLAGEN | → |
|---|---|

**FIG.1D**

| RESTLICHE PHOTOWIDER- STANDSSCHICHTEN ABHEBEN | → |
|---|---|

**FIG.1E**